(19)

Europäisches
Patentamt
European
Patent Office
Office européen
des brevets

(11) **EP 2 023 341 B1**

(12) **EUROPEAN PATENT SPECIFICATION**

(45) Date of publication and mention
of the grant of the patent:
**03.03.2021 Bulletin 2021/09**

(51) Int Cl.:
***G10L 19/038*** *(2013.01)*

(21) Application number: **08160878.8**

(22) Date of filing: **22.07.2008**

(54) **VECTOR CODING/DECODING METHOD AND APPARATUS AND STREAM MEDIA PLAYER**

VERFAHREN UND VORRICHTUNG FÜR VEKTORVERSCHLÜSSELUNG/-ENTSCHLÜSSELUNG
SOWIE STREAMING-MEDIENSPIELER

PROCÉDÉ DE CODAGE/DÉCODAGE DE VECTEURS ET APPAREIL ET LECTURE DE MÉDIA EN
CONTINU

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **23.07.2007 CN 200710129604
30.06.2008 PCT/CN2008/071481**

(43) Date of publication of application:
**11.02.2009 Bulletin 2009/07**

(73) Proprietor: **Huawei Technologies Co., Ltd.
Longgang District
Shenzhen, Guangdong 518129 (CN)**

(72) Inventor: **Ma, Fuwei
Guangdong 518129 (CN)**

(74) Representative: **Kreuz, Georg Maria et al
Huawei Technologies Duesseldorf GmbH
Riesstraße 25
80992 München (DE)**

(56) References cited:
• **"Digital cellular telecommunications system
(Phase 2+); Universal Mobile
Telecommunications System (UMTS); Audio
codec processing functions; Extended Adaptive
Multi-Rate - Wideband (AMR-WB+) codec;
Transcoding functions (3GPP TS 26.290 version
7.0.0 Release 7); ETSI TS 126 290" ETSI
STANDARDS, LIS, SOPHIA ANTIPOLIS CEDEX,
FRANCE, vol. 3-SA4, no. V7.0.0, 1 March 2007
(2007-03-01), XP014038016 ISSN: 0000-0001**

• **MINJIE XIE ET AL: "Embedded algebraic vector
quantizers (EAVQ) with application to wideband
speech coding" 1996 IEEE INTERNATIONAL
CONFERENCE ON ACOUSTICS, SPEECH, AND
SIGNAL PROCESSING - PROCEEDINGS.
(ICASSP). ATLANTA, MAY 7 - 10, 1996; [IEEE
INTERNATIONAL CONFERENCE ON
ACOUSTICS, SPEECH, AND SIGNAL
PROCESSING - PROCEEDINGS. (ICASSP)], NEW
YORK, IEEE, US, vol. 1, 7 May 1996 (1996-05-07),
pages 240-243, XP002252600 ISBN:
978-0-7803-3193-8**

• **LAMBLIN C ET AL: "ALGORITHME DE
QUANTIFICATION VECTORIELLE SPHERIQUE A
PARTIR DU RESEAU DE GOSSET D'ORDRE 8.
SPHERICAL VECTOR QUANTIZATION
ALGORITHM BASED ON AN EIGHT
DIMENSIONAL GOSSET LATTICE" ANNALES
DES TELECOMMUNICATIONS, LES
MOULINEAUX, FR, vol. 43, no. 3/04, 1 March 1988
(1988-03-01), pages 172-186, XP000572495**

• **CHEN C ET AL: "A novel scheme for optimising
partitioned VQ using a modified resolution
measure" SIGNAL PROCESSING, ELSEVIER
SCIENCE PUBLISHERS B.V. AMSTERDAM, NL,
vol. 56, no. 2, 1 January 1997 (1997-01-01), pages
157-163, XP004057084 ISSN: 0165-1684**

• **"Vector quantization", Wikipedia, 20 July 2007
(2007-07-20), Retrieved from the Internet:
URL:https://en.wikipedia.org/w/index.php?t
itle=Vector_quantization&oldid=145814485
[retrieved on 2019-06-10]**

EP 2 023 341 B1

**Description**

**Field of the Invention**

The present invention relates to codec technologies and in particular to a vector coding/decoding method and apparatus and a stream media player.

**Background of the Invention**

Vector quantization technologies are usually deployed in stream media coding, a common one of the technologies is lattice vector quantization which is quite widely used in low-rate scenarios. In audio coding, for example, the quantization technology deployed in Transform Code Excite (TCX) part of the widely used Extend Adaptive Multi-Rate Wideband codec (AMR-WB+) audio coding algorithm is a multi-rate lattice vector quantization technique built on $RE_8$.

In the TCX part of the AMR-WB+ audio coding algorithm, the multi-rate lattice vector quantization approach is applied as the quantization approach. The multi-rate lattice vector quantization approach is applied on preshaped spectral data by groups each consisted of eight values, and quantizes the eight values as elements in the $RE_8$ set based on a principle of proximity. In the algorithm, a set of elements is selected from the $RE_8$ with the quantization, which is defined as $RE_8 = 2D_8 \cup \{2D_8 + (1,...,1)\}$, where $D_8 = \{(x_1, x_2, \cdots, x_8) \in Z^8 \,|x_1 + \cdots + x_8 \text{ is even}\}$. Therefore, the sum of all elements in the $RE_8$ set is a multiple of 4. Thus, the quantization approach includes searching the $2D_8$ set for an element closest to the original data, searching the $2D_8 + (1,1,1,...,1)$ set for an element closest to the original data, and comparing the two elements searched out to obtain a result, i.e. an initial vector, which is a group of integer data $(x_0, x_1,..., x_{n-1})$ denoted by $c_k$. Because the inputted data is divided into groups each consisted of eight values, the resulting $c_k$ is actually $(x_0, x_1,...,x_7)$.

Subsequently, basic codebooks of $Q_0, Q_2, Q_3, Q_4$ are searched for the $c_k$. If no $c_k$ is found in the basic codebooks, the basic codebooks are extended with the $c_k$ through Voronoi extension, so that a corresponding basic codebook index and an extended codebook index are determined. The basic codebooks of $Q_0, Q_2, Q_3, Q_4$ are shown in Table 1 below.

Table 1 Basic codebooks

| Sphere | Ka | Leader | Combination | Sign | Size | $Q_0$ | $Q_2$ | $Q_3$ | $Q_4$ |
|---|---|---|---|---|---|---|---|---|---|
| 0 | | {0, 0, 0, 0, 0, 0, 0, 0} | | | 1 | X | | | |
| 2 | 0 | {1, 1, 1, 1, 1, 1, 1, 1} | 1 | 128 | 128 | | X | X | |
| 8 | 1 | { 2, 2, 0, 0, 0, 0, 0, 0} | 28 | 4 | 112 | | X | X | |
| 16 | 2 | { 2, 2, 2, 2, 0, 0, 0, 0} | 70 | 16 | 1120 | | | X | |
| 22 | 3 | {3, 1, 1, 1, 1, 1, 1, 1} | 8 | 128 | 1024 | | | X | |
| 64 | 4 | { 4, 0, 0, 0, 0, 0, 0, 0} | 8 | 2 | 16 | | X | X | |
| 24 | 5 | { 2, 2, 2, 2, 2, 2, 0, 0} | 28 | 64 | 1792 | | | | X |
| 42 | 6 | {3, 3, 1, 1, 1, 1, 1, 1} | 28 | 128 | 3584 | | | | X |
| 72 | 7 | { 4, 2, 2, 0, 0, 0, 0, 0} | 168 | 8 | 1344 | | | X | |
| 32 | 8 | { 2, 2, 2, 2, 2, 2, 2, 2} | 1 | 256 | 256 | | | | X |
| 62 | 9 | {3, 3, 3, 1, 1, 1, 1, 1 } | 56 | 128 | 7168 | | | | X |
| 80 | 10 | { 4, 2, 2, 2, 2, 0, 0, 0} | 280 | 32 | 8960 | | | | X |
| 128 | 11 | { 4, 4, 0, 0, 0, 0, 0, 0} | 28 | 4 | 112 | | | X | |
| 158 | 12 | {5, 1, 1, 1, 1, 1, 1, 1} | 8 | 128 | 1024 | | | | X |
| 82 | 13 | {3, 3, 3, 3, 1, 1, 1, 1} | 70 | 128 | 8960 | | | | X |
| 88 | 14 | { 4, 2, 2, 2, 2, 2, 2, 0} | 56 | 128 | 7168 | | | | X |
| 136 | 15 | { 4, 4, 2, 2, 0, 0, 0, 0} | 420 | 16 | 6720 | | | | X |
| 178 | 16 | {5, 3, 1, 1, 1, 1, 1, 1} | 56 | 128 | 7168 | | | | X |
| 328 | 17 | { 6, 2, 0, 0, 0, 0, 0, 0} | 56 | 4 | 224 | | | X | |

(continued)

| Sphere | Ka | Leader | Combination | Sign | Size | $Q_0$ | $Q_2$ | $Q_3$ | $Q_4$ |
|---|---|---|---|---|---|---|---|---|---|
| 192 | 18 | { 4, 4, 4, 0, 0, 0, 0, 0} | 56 | 8 | 448 | | | | X |
| 336 | 29 | { 6, 2, 2, 2, 0, 0, 0, 0} | 280 | 16 | 4480 | | | | X |
| 392 | 20 | { 6, 4, 2, 0, 0, 0, 0, 0} | 336 | 8 | 2688 | | | | X |
| 1202 | 21 | { 7, 7, 1, 1, 1, 1, 1, 1 } | 8 | 128 | 1024 | | | | X |
| 1024 | 22 | { 8, 0, 0, 0, 0, 0, 0, 0} | 8 | 2 | 16 | | | | X |
| 648 | 23 | { 6, 6, 0, 0, 0, 0, 0, 0} | 28 | 4 | 112 | | | | X |
| 1032 | 24 | {8, 2, 2, 0, 0, 0, 0, 0} | 168 | 8 | 1344 | | | | X |
| 1088 | 25 | {8, 4, 0, 0, 0, 0, 0, 0} | 56 | 4 | 224 | | | | X |
| 1642 | 26 | {9, 1, 1, 1, 1, 1, 1, 1} | 8 | 128 | 1024 | | | | X |
| 2504 | 27 | { 10, 2, 0, 0, 0, 0, 0, 0} | 56 | 4 | 224 | | | | X |
| 2048 | 28 | { 8, 8, 0, 0, 0, 0, 0, 0} | 28 | 4 | 112 | | | | X |
| 2824 | 39 | { 10, 6, 0, 0, 0, 0, 0, 0} | 56 | 4 | 224 | | | | X |
| 5184 | 30 | {12, 0, 0, 0, 0, 0, 0, 0} | 8 | 2 | 16 | | | | X |
| 5248 | 31 | { 12, 4, 0, 0, 0, 0, 0, 0} | 56 | 4 | 224 | | | | X |
| 5000 | 32 | {10, 10, 0, 0, 0, 0, 0, 0} | 28 | 4 | 112 | | | | X |
| 9608 | 33 | { 14, 2, 0, 0, 0, 0, 0, 0} | 56 | 4 | 224 | | | | X |
| 6208 | 34 | { 12, 8, 0, 0, 0, 0, 0, 0} | 56 | 4 | 224 | | | | X |
| 16384 | 35 | {16, 0, 0, 0, 0, 0, 0, 0} | 8 | 2 | 16 | | | | X |

Characteristic codebooks shown in Table 1, i.e. leaders, are distributed on the respective spheres. The Sphere indicates the size of a sphere, the Size indicates a number of the codewords derived from permutation and combination of the leader, and the Ka identifies the respective leaders, with each leader being identified by a different Ka value. The value of Sphere(S) is a quarter of the sum of all components of the leader each to the power of four, i.e.

$$S = \frac{1}{4}(x_1^4 + x_2^4 + ... + x_7^4 + x_8^4).$$ Each leader corresponds to an S having a different value. In the coding, each value of S corresponds to a value of ka. In the case of an 8-dimensional vector, a corresponding ka can be searched out with only the calculated value of S of the 8-dimensional vector, and thus a leader to which the value of S belongs may be determined from the value of ka. The basic codebooks of the leaders are further shown in Table 1. The basic codebooks are divided into $Q_0$, $Q_2$, $Q_3$ and $Q_4$. The $Q_0$ contains only one leader, and the $Q_2$, $Q_3$, and $Q_4$ contain 3, 8 and 28 leaders respectively, where $Q_2 \subset Q_3$, and $Q_3 \not\subset Q_4$, as shown in Table 1.

After the basic codebook to which the $c_k$ belongs is determined, assuming that the $c_k$ is a sample from a set of elements $(a_0, a_1,...,a_{q-1})$ and $w(i)$ is the number of element $a_i$ in the sample, thus the number of possible states of Leader L is $k(l)$ given as follows:

$$K(l) = C_n^{w_0} + \prod_{i=1}^{q-1} C_{n-\sum_{j=0}^{i-1} w_i}^{w_i} = \frac{n!}{\prod_{i=0}^{q-1} w_i!}$$

If $d(k) = i$, $x_k = a_i$, and $w_i^k$ is the number of element $a_i$ in $(x_0, x_1,..., x_{n-1})$, an index of the $(x_0, x_1,..., x_{n-1})$ is coded as follows:

$$t = \sum_{k=1}^{n} \frac{(n - 1 - k)}{\prod_{i=0}^{q=1} (w_i^k)!} \left( \sum_{j=0}^{d(k)-1} w_i^k \right)$$

In decoding, vector $d(k)$ is obtained in sequence using the formula below, where k=0,...7:

$$I(d(k)-1,k) \le t - \sum_{j=0}^{k-1} I(d(j)-1,j) < I(d(k),k)$$

$$I(p,k) = \frac{(n - 1 - k)!}{\prod_{I=0}^{q-1} (w_i^k)!} \sum_{j=0}^{p} w_j^k$$

Then $(x_0, x_1,..., x_{n-1})$ is derived from $d(k)$ based on that $d(k) = i$ and $x_k = a_i$.

The above solution is disadvantageous at least in that multiple irregular factorials are calculated during coding and decoding, furthermore, the calculation of these random factorials can hardly be simplified by lookup process, resulting in high calculation complexity.

US2007/0162236 provides a supplementary structuring property according to a union of permutation codes and an index of this union of permutation codes is utilized in the implementation of the following steps:

CP1)on the basis of an input signal, an input vector y defined by its absolute vector |y| and by a sign vector ε with ε =±1 is formed,

CP2)the components of the vector |y| are ranked by decreasing values, by permutation, to obtain a leader vector |y|,

CP3)a nearest neighbour $x^{j'}$ of the leader vector $|\hat{j}|$ is determined from among the leader vector of the dictionary $D^j_i$, of dimension j,

CP4)an index of the rank of said nearest neighbour $x^{j'}$ in the dictionary $D^j_i$, is determined,

CP5)and an effective value of coding/decoding is applied to the input vector, which is dependent on said index determined in step CP4), on said permutation determined in step CP2) and on said sign vector determined in step CP1).

## Summary of the Invention

An embodiment of the present invention provides a vector coding/decoding method and apparatus and a stream media player, thereby reducing calculation complexity.

An embodiment of the present invention provides a vector coding method, including:

decomposing an initial vector to obtain a sign vector and an initial absolute vector, wherein the initial vector corresponds to a leader;

coding the sign vector to obtain a sign code;

performing multi-level permutation-based coding on the initial absolute vector to obtain an absolute vector code;

combining the sign code and the absolute vector code to obtain a code of the initial vector by adding the absolute vector code shifted left by the number of bits of the sign code to the sign code; and

coding a value which uniquely identifies the leader;

wherein coding the sign vector to obtain a sign code comprises: coding signs in the sign vector which correspond to non-zero elements from the inputted vector in order, to obtain the sign code, wherein for each element 1 represents a positive sign and 0 represents a negative sign, or 0 represents a positive sign and 1 represents a negative sign;

wherein performing multi-level permutation-based coding on the initial absolute vector comprises:

(a) removing from the initial absolute vector any element according to a decomposition order, wherein the decomposition order is to remove the most frequent element from the initial absolute vector, or remove the smallest element if two or more most frequent elements exist from the initial absolute vector, thereby constructing a new absolute vector with elements not removed, wherein the decomposition order is determined by the leader;

(b) performing coding on positions of the elements not removed in the initial absolute vector to obtain a position code;

(c) proceeding with the multi-level permutation-based coding by repeating steps (a) and (b) on the new absolute vector if the number of elements in the new absolute vector is larger than 1, till the number of the elements in the new absolute vector is one; and

(d) obtaining the absolute vector code by combining all the position codes obtained in the multi-level permutation-based coding if the number of the elements in the new absolute vector is 1.

An embodiment of the present invention provides a vector coding apparatus, configured to perform any of the methods according to claim 1 to 3.

As can be seen from the above technical solution that no calculation using complex formula is performed to code absolute vector with multi-level permutation-based coding approach, so that calculation complexity is reduced.

**Brief Description of the Drawings**

Figure 1 is a flow chart of the vector coding method according to a first embodiment of the present invention;

Figure 2 is a flow chart of the vector coding method according to a second embodiment of the present invention;

Figure 3a is a schematic diagram of an example of position code table of index83 according to an embodiment of the present invention;

Figure 3b is a schematic diagram of an example of position code table of index32 according to an embodiment of the present invention;

Figure 4 is a flow chart of the vector coding method according to a third embodiment of the present invention;

Figure 5 is a flow chart of the vector decoding method according to a first embodiment of the present invention;

Figure 6 is a flow chart of the vector decoding method according to a second embodiment of the present invention;

Figure 7 is a structural diagram illustrating an example of the vector coding apparatus according to an embodiment of the present invention; and

Figure 8 is a structural diagram illustrating an example of the vector decoding apparatus according to an embodiment of the present invention.

**Detailed Description of the Embodiments**

The present invention is described in details below illustratively with reference to the drawings for better understanding of objects, solutions and advantages of the present invention.

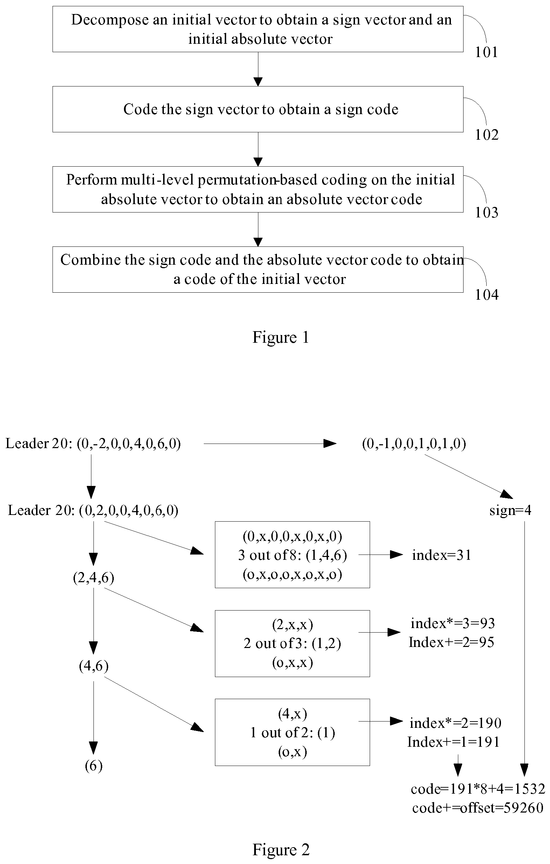

As shown in Figure 1, the vector coding method according to an embodiment of the present invention includes the following steps. It shall be noted that stream media in the description refer to multimedia applying streaming technologies, such as video and audio. For the sake of description, only audio is described in the description, and processes on other stream media such as video are similar to those on audio.

Step 101. An initial vector is decomposed to obtain a sign vector and an initial absolute vector.

A sign of an element in the initial vector may be positive or negative, and there are numerous possible combinations of the positive and negative signs. Therefore, by decomposing the initial vector to obtain the sign vector, the number of combinations of elements in the initial vector may be reduced, thereby reducing subsequent amount of calculation.

Step 102. A sign code is obtained by coding the sign vector.

A sign of each of all the elements may be picked up directly. Alternatively, signs of only non-zero elements may be picked up after a sign of any zero element is removed, and thus data bits to be occupied by integer value of the sign vector is reduced.

The integer value of the sign vector may be obtained using a scheme provided in an embodiment of the present invention. In the scheme, a sign of any element in the initial vector having a value of zero is removed from the sign vector, the signs of the non-zero elements are arranged in an order in which the non-zero elements are arranged in the initial vector, and thus a sign code is obtained, with "1" representing a positive sign and "0" representing a negative sign, or "0" representing the positive sign and "1" representing the negative sign, so that the sign code corresponding to the sign vector of the initial vector is obtained and the number of bits of the sign code equals to the number of the non-zero elements in the initial vector. As described above, while "1" and "0" are used in the case of binary, other values may be used in the case of, for example, octal, decimal, etc. The arrangement order in the description is described as from left to right. However in practice, the arrangement order may be from right to left or from middle to right and left, and processes are similar to those in the case of the arrangement order from left to right and description thereof are omitted herein.

Furthermore in practice, a post-process is required for the sign code, because a constraint exists in designing a basic codebook for a quantization process, in other words, a sum of values of all elements in a vector needs to be a multiple of 4. If a variance of the sum of values of all elements due to a change on a sign of any individual element is a multiple of 4, the signs of the individual elements are independent; otherwise, the signs of the individual elements are dependent, which means that correlation and redundancy between the signs exists, and the redundancy between the signs needs to be eliminated for the purpose of efficient coding. Because any dependent sign of the initial vector may be determined by other sign bits, a simple approach of eliminating redundancy is not to code the sign of the last non-zero element of the initial vector among the dependent signs, i.e. to remove the last bit of the obtained sign code, so as to satisfy the condition that a sum of values of all elements in a vector needs to be a multiple of 4. The sign of the remaining one element may be derived directly from known signs of other elements of the vector.

Step 103. Multi-level permutation-based coding is performed on the initial absolute vector to obtain an absolute vector code.

The multi-level permutation-based coding is to remove level by level an element of the initial absolute vector which satisfies a preset condition, for example, an element corresponding to the most frequent element value. If two or more most frequent element values are present, elements corresponding to which may be removed in order of their values. Of course, the elements may also be selected and removed using other means depending on specific application environment. In practice, all elements corresponding to two or more most frequent element values may be removed.

In multi-level permutation-based coding, for elements remaining at the current level, data on their positions at an upper level constitutes a position permutation, a possible value of the position permutation is the number of elements belonging to the upper level, and the obtained position permutation at the current level is coded. In this way, the multi-level permutation-based coding is performed on the absolute vector until an element at the decomposition level corresponds to only one element value, as a result, a series of level-based coded values are obtained and the absolute vector code is obtained by combining the level-based coded values. In practice, in the multi-level permutation-based coding, the level-based coded values may be combined level by level, or combined at a time after all the level-based coded values are obtained. In the description of the present invention hereinafter, the way that the level-based coded values are combined level by level is taken as an example for illustration.

Step 104. The sign code and the absolute vector code are combined to obtain a code of the initial vector.

The code of the initial vector may be obtained by combining the sign code and the absolute vector code, so that in decoding, the absolute vector and the sign vector of elements of the absolute vector can be decoded from the code of the initial vector. A specific combination process includes: after determining the number of bits of the sign code, combining the absolute vector code shifted left by the number and the sign code, thereby obtaining the code of the initial vector.

In practice, it is also possible to combine the absolute vector code shifted right and the sign code. Alternatively, it is possible to combine the sign code shifted left or right and the absolute vector code after the number of bits of the absolute vector code is determined. The present invention is not limited to a particular approach of combining the absolute vector code and the sign code, and all approaches of deriving a sign code and an absolute vector code from a code of an initial vector in decoding are intended to fall within the scope of the present invention.

As can be seen from the above description that no calculation using complex formula is performed to code absolute vector with multi-level permutation-based coding approach in embodiments of the present invention, so that calculation complexity is reduced.

In practice, multiple characteristic codebooks may be present, in other words, at least two characteristic codebooks exist in the codebook space. In this case, after a coded value of the initial vector, which belongs to a characteristic codebook, is obtained, it is required to proceed with:

obtaining a characteristic value of the characteristic codebook to which the initial vector belongs in the codebook space, combining the characteristic value and the code of the initial vector which belongs to the characteristic codebook, and obtaining a resulting code of the initial vector.

Characteristic values of the individual characteristic codebooks in the codebook space are different, and the characteristic value may be an entirely shifted value of the characteristic codebook in the codebook space, or other value which may uniquely identify the characteristic codebook in the codebook space, such as a serial number of the characteristic codebook. Accordingly, by combining the code of the initial vector which belongs to the characteristic codebook and the characteristic value, the code is mapped to characteristic codebook, so that the corresponding codebook may be used for decoding. The specific procedure of the combination is same as that of combining an integer value of a sign vector and a code of an initial vector. In practice, when an entirely shifted value of a characteristic codebook in the codebook space is used as the characteristic value, due to an interval between entirely shifted values of the respective characteristic codebooks in the codebook space, a final coded value may be obtained by adding the code of the initial vector which belongs to the characteristic codebook and the entirely shifted value if the interval is sufficiently large.

After the above steps, an initial vector may be mapped to a corresponding characteristic codebook in the case of multiple characteristic codebooks.

When the method according to the embodiment of the present invention is deployed in a transform-domain lattice vector quantization coding in a speech audio standard, due to that all basic codebooks for the lattice vector quantization coding are constant, element types of each Leader and the number of elements of each type are determined, and an order of multi-level permutation-based coding, configuration parameters, etc., may be determined in advance according to the Leader. In the case of the codebook of the basic codebooks shown in Table 1, for example, the order of multi-level permutation-based coding and the configuration parameters according to an embodiment of the present invention are shown in Table 2, where an element corresponding to the most frequent element value is removed level by level.

Table 2 Order of multi-level permutation-based coding and configuration parameters

| Ka | Leader | Decomposition order | Sn, Vc, m1, m2, m3 |
|---|---|---|---|
|  | {0, 0, 0, 0, 0, 0, 0, 0} |  |  |
| 0 | {1, 1, 1, 1, 1, 1, 1, 1} | {1} | {7, 1} |
| 1 | {2, 2, 0, 0, 0, 0, 0, 0 } | {0, 2} | {2, 2, 2} |
| 2 | {2, 2, 2, 2, 0, 0, 0, 0 } | {0, 2} | {4, 2, 4} |
| 3 | {3, 1, 1, 1, 1, 1, 1, 1} | {1, 3} | {7, 2, 1} |
| 4 | {4, 0, 0, 0, 0, 0, 0, 0 } | {0, 4} | {1, 2, 1} |
| 5 | {2, 2, 2, 2, 2, 2, 0, 0 } | {2, 0} | {6, 2, 2} |
| 6 | {3, 3, 1, 1, 1, 1, 1, 1} | {1, 3} | {7, 2, 2} |
| 7 | {4, 2, 2, 0, 0, 0, 0, 0 } | {0, 2, 4} | {3, 3, 3, 1 } |
| 8 | {2, 2, 2, 2, 2, 2, 2, 2} | {2} | {8, 1} |
| 9 | {3, 3, 3, 1, 1, 1, 1, 1} | {1, 3} | {7, 2, 3} |
| 10 | {4, 2, 2, 2, 2, 0, 0, 0 } | {2, 0, 4} | {5, 3, 4, 1} |
| 11 | {4, 4, 0, 0, 0, 0, 0, 0} | {0, 4} | {2, 2, 2 } |
| 12 | {5, 1, 1, 1, 1, 1, 1, 1} | {1, 5} | {7, 2, 1} |
| 13 | {3, 3, 3, 3, 1, 1, 1, 1} | {1, 3} | {7, 2, 4} |
| 14 | {4, 2, 2, 2, 2, 2, 2, 0 } | {2, 0, 4} | {7, 3, 2, 1} |
| 15 | {4, 4, 2, 2, 0, 0, 0, 0} | {0, 2, 4} | {4, 3, 4, 2 } |
| 16 | {5, 3, 1, 1, 1, 1, 1, 1} | {1, 3, 5} | {7, 3, 2, 1} |
| 17 | {6, 2, 0, 0, 0, 0, 0, 0 } | {0, 2, 6} | {2, 3, 2, 1} |

(continued)

| Ka | Leader | Decomposition order | Sn, Vc, m1, m2, m3 |
|---|---|---|---|
| 18 | {4, 4, 4, 0, 0, 0, 0, 0} | {0, 4} | {3, 2, 3} |
| 19 | {6, 2, 2, 2, 0, 0, 0, 0 } | {0, 2, 6} | {4, 3, 4, 1} |
| 20 | {6, 4, 2, 0, 0, 0, 0, 0} | {0, 2, 4, 6} | {3, 4, 3, 2, 1 } |
| 21 | {7, 7, 1, 1, 1, 1, 1, 1} | {1, 7} | {7, 2, 1} |
| 22 | {8, 0, 0, 0, 0, 0, 0, 0 } | {0, 8} | {1, 2, 1} |
| 23 | {6, 6, 0, 0, 0, 0, 0, 0} | {0, 6} | {2, 2, 2} |
| 24 | {8, 2, 2, 0, 0, 0, 0, 0} | {0, 2, 8} | {3, 3, 3, 1 } |
| 25 | {8, 4, 0, 0, 0, 0, 0, 0} | {0, 4, 8} | {2, 3, 2, 1 } |
| 26 | {9, 1, 1, 1, 1, 1, 1, 1} | {1, 9} | {7, 2, 1} |
| 27 | { 10, 2, 0, 0, 0, 0, 0, 0} | {0, 2, 10} | {2, 3, 2, 1} |
| 28 | {8, 8, 0, 0, 0, 0, 0, 0} | {0, 8} | {2, 2, 2} |
| 29 | {10, 6, 0, 0, 0, 0, 0, 0} | {0, 6, 10} | {2, 3, 2, 1} |
| 30 | {12, 0, 0, 0, 0, 0, 0, 0 } | {0, 12} | {1, 2, 1} |
| 31 | {12, 4, 0, 0, 0, 0, 0, 0} | {0, 4, 12} | {2, 3, 2, 1} |
| 32 | { 10, 10, 0, 0, 0, 0, 0, 0 } | {0, 10} | {2, 2, 2} |
| 33 | {14, 2, 0, 0, 0, 0, 0, 0} | {0, 2,14} | {2, 3, 2, 1} |
| 34 | {12, 8, 0, 0, 0, 0, 0, 0} | {0, 8, 12} | {2, 3, 2, 1} |
| 35 | {16, 0, 0, 0, 0, 0, 0, 0} | {0, 16 | {1, 2, 1} |

Table 2 shows a decomposition order corresponding to each Leader, i.e. element values removed level by level, as shown in the column of decomposition order. Each element in the Leader is removed level by level based on a value of the element in accordance with data in the column of decomposition order from left to right. Data of m1, m2 and m3 in the last column denote respectively values of numbers (m) of elements for permutation-based coding at levels 1, 2 and 3, m at an upper level equals to a value of a number (n) of elements at the current level, and a value of n of the permutation-based coding at the first level is a dimension of the lattice vector (for example, n is 8 for $RE_8$). Data Vc in the last column denotes the number of element types in the terms of an absolute value in the Leader, i.e. the number of levels of the multi-level permutation-based coding. Data Sn in the last column denotes the number of bits of a sign code.

The vector coding method according to an embodiment of the present invention is described below in a specific embodiment. As shown in Figure 2, calculated data at each stage of the vector coding belonging to Leader 20 is described.

By decomposing elements in vector of (0, -2, 0, 0, 4, 0, 6, 0) belonging to Leader 20, an absolute vector of (0, 2, 0, 0, 4, 0, 6, 0) and a sign vector of (0, -1, 0, 0, 1, 0, 1, 0) are obtained.

After 0s are removed from the sign vector, a binary sign code of 100 is obtained with "1" representing the negative sign and "0" representing the positive sign. The binary 100 is a decimal 4, thus the sign code Sign=4.

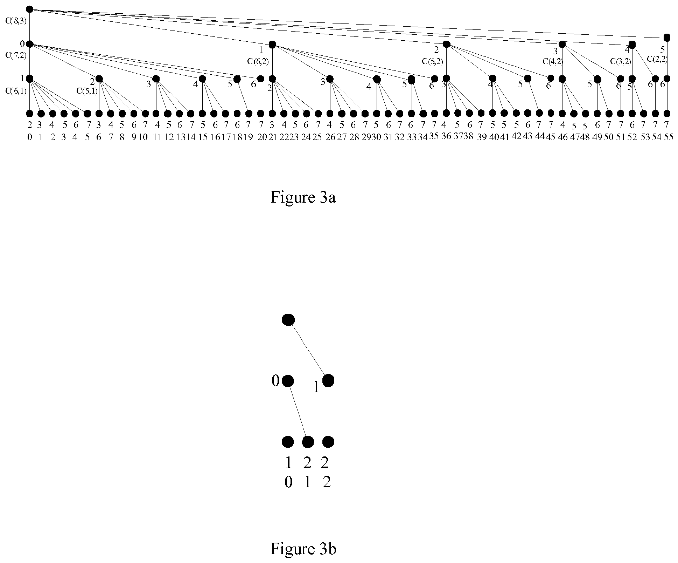

With reference to Table 2, to perform multi-level permutation-based coding on the absolute vector, elements having a value of 0 in the absolute vector are removed to obtain an absolute vector of (2, 4, 6). For the elements of 2, 4 and 6, data on their positions at an upper level are 1, 4 and 6 respectively. In this case, three elements are selected from eight elements in accordance with a combination principle, and a corresponding position code may be calculated with a preset formula, i.e. $index83 = C_8^3 - C_{8-p0}^3 + C_{8-p0-1}^2 - C_{8-p1}^2 + C_{8-p1-1}^1 - C_{8-p2}^1$, where p0 denotes the position data of "2", p1 denotes the position data of "4", and p2 denotes the position data of "6". Alternatively, the position code may be searched out from a preset position code table, an example of which in an embodiment of the present invention is shown in Figure 3a. The position code corresponding to the respective position data of 1, 4 and 6 is 31, as can be seen from Figure 3a.

Subsequently, the multi-level permutation-based coding is proceeded with on the obtained absolute vector which has three elements. Because the three elements correspond to three different element values, one element is removed from the three elements in order. With reference to Table 2, an element having a value of 2 is removed, obtaining an absolute vector of (4, 6) having two elements. Because the position code at the upper level is 31, a combined position code of 31*3+2=95 is obtained by combining the position code at the current level and the position code at the upper level. The reason for timing 3 is that the number of combinations obtained from selecting two elements from three elements is 3, and the reason for adding 2 is that the data of positions in the vector of (2, 4, 6) for the elements of 4 and 6 from the obtained absolute vector of (4, 6) is 1 and 2 and a position code of 2 is obtained in accordance with a formula

of $index32 = C_3^2 - C_{3-p0}^2 + C_{3-p0-1}^1 - C_{3-p1}^1$, where p0 denotes the position data of the element of "4", and p1 denotes the position data of the element of "6". Of course, the position code may be also searched out from a preset position code table, an example of which in an embodiment of the present invention is shown in Figure 3b. The position code corresponding to the respective position data of 1 and 2 is 2, as can be seen from Figure 3b.

Likewise, the multi-level permutation-based coding is proceeded with on the obtained absolute vector which has two elements. With reference to Table 2, an element having a value of 4 is removed, obtaining an absolute vector of (6) having only one element. The position code at the upper level is 95, the number of combinations obtained from selecting one element from two elements is 2, and the data on position in the vector of (4, 6) for the element of 6 is 1, therefore a position code of 1 is obtained in accordance with a formula of $index21 = C_2^1 - C_{2-p0}^1$, where p0 denotes the data on position in the vector of (4, 6) for the element of "6". As a result, the combined position code is 95*2+1=191.

At this point, the multi-level permutation-based coding is completed because the number of element value in the obtained absolute vector is 1. Because the number of non-zero elements among initial elements in the absolute vector is 3, in other words, the number of bits of the integer value of the sign vector is 3, in order to combine the sign code and the absolute vector code, the absolute vector code is shifted left by 3 bits and added to the sign code, so that the absolute vector code and the sign code are combined and stored, and a coded value of the initial vector which belongs to Leader 20 is obtained as 191*(2³)+4=191*8+4=1532, where 4 is the sign code. Subsequently, the code belonging to Leader 20 and the entirely shifted value of Leader 20 in the codebook space are combined, and the obtained final coded value is 59260 given that the entirely shifted value of Leader 20 in the codebook space is 57728. The entirely shifted value of Leader 20 in the codebook space is dependent upon the storage position of Leader 20 in a system, and may vary from system to system, but is constant in a system.

As can be seen from the above description that no complex factorial is calculated and amount of calculation is low. Furthermore, it is required to store only a table shown as Table 2, formulas for calculating a position code or a position code table used in searching for a position code, and a little of temporal data in an embodiment, therefore not much storage space is occupied. In the embodiment, any element corresponding to one element value are removed at each level; however in practice with many element values, elements corresponding to multiple element values may be removed at each level.

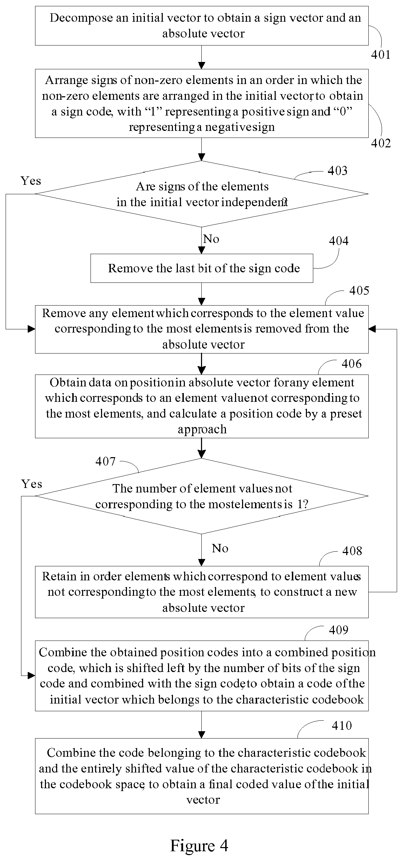

The method according to the third embodiment of the present invention is shown in Figure 4, and the method includes the following steps.

Step 401. A sign vector and an absolute vector are obtained by decomposing an initial vector.

Step 402. The signs of non-zero elements are arranged in an order in which the non-zero elements are arranged in the initial vector, and thus a sign code is obtained, with "1" representing the positive sign and "0" representing the negative sign.

In practice, the sign code may be obtained with "0" representing the positive sign and "1" representing the negative sign, or otherwise.

Step 403. It is determined whether the signs of the elements in the initial vector are independent. If the signs are independent, the method proceeds to Step 405, otherwise the method proceeds to Step 404.

Step 404. The last bit of the sign code is removed.

Step 405. Any element which corresponds to the element value corresponding to the most elements is removed form the absolute vector.

In the embodiment, an approach that any element which corresponds to the element value corresponding to the most elements is removed from the absolute vector is deployed. However in practice, an approach that any element which corresponds to the element value corresponding to the least elements is removed from the absolute vector may be deployed.

Step 406. For elements which correspond to element values not corresponding to the most elements, their data on the positions in the absolute vector is obtained, and a position code is obtained by a preset approach.

The preset approach may be that the position code is calculated using a formula for calculating a position code or searched out in a preset position code table.

Step 407. It is determined whether the number of element values not corresponding to the most elements is 1; and if the number is 1, the process proceeds to Step 409; otherwise, the process proceeds to Step 408.

Step 408. Elements corresponding to element values not corresponding to the most elements are retained in order, to construct a new absolute vector, and the process proceeds to Step 405.

Step 409. The obtained position codes are combined into a combined position code, which is shifted left by the number of bits of the sign code and combined with the sign code, to obtain a code of the initial vector which belongs to the characteristic codebook determined from the initial vector.

Step 410. The code belonging to the characteristic codebook and the entirely shifted value of the characteristic codebook in the codebook space are combined, to obtain a final coded value of the initial vector.

The multi-level permutation-based coding is deployed in the embodiment, no complex factorial is calculated and amount of calculation is low. Furthermore, not much temporal data is required to be stored in the embodiment, and therefore not much storage space is occupied.

A vector decoding method corresponding to the vector coding method is provided in an embodiment of the present invention. After receiving the resulting code of an initial vector, a decoding side decomposes a value to be decoded in accordance with an approach opposite to the coding, obtains permutation-based decoding values of the respective parts, obtains position information by decoding, and multi-level replacement is performed, to obtain the resulting initial vector. The decoding includes: (1) searching the range of the coded value to obtain a Leader to which the lattice vector belongs, thereby obtaining a shift value of the code, and subtracting the shift value from the coded value to obtain a coded value in the Leader; (2) decomposing the coded value in the Leader, to obtain a value of sign code and a value of multi-level permutation-based code; (3) decomposing level by level the value of multi-level permutation-based code to obtain values of permutation-based code at each level, obtaining position vectors at each level through parse using a permutation-based decoding module, and restoring element values at all positions in the initial vector using multi-level replacement approach.

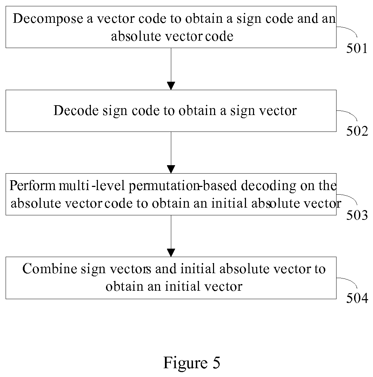

As shown in Figure 5, the vector decoding method according to an embodiment of the present invention includes:

Step 501. A vector code is decomposed, to obtain a sign code and an absolute vector code.

A characteristic codebook corresponding to the vector may be obtained from the vector code, and the number of bits of the sign code corresponding to the vector code may be searched out from a preset decoding table.

The sign code indicates signs of elements in the initial vector. The number of elements in each characteristic codebook is known, therefore the number of bits of the sign code is determined from the determined characteristic codebook, and all of these may be stored in the preset decoding table.

Data on bits of a sign code is extracted from the vector code, to obtain the sign code. Due to that the vector code is constructed by the absolute vector code and the sign code jointly, if the coded value of the characteristic codebook is obtained from combining the absolute vector code shifted left and the sign code in coding, the several most right bits of the vector code is the sign code

To obtain the absolute vector code, the vector code from which the data on the bits of the sign code has been extracted is shifted right by the number of bits of the sign code. After the sign code is extracted, the data from which the sign code has been extracted is shifted right by the number of bits, thereby obtaining the absolute vector code, which is inverse to the procedure of coding.

Step 502. The sign code is decoded to obtain a sign vector.

The obtained integer value of sign vector is converted as binary. The signs of elements are determined dependent upon whether "0" represents the positive sign and "1" represents the negative sign or "0" represents the negative sign and "1" represents the positive sign in coding. In this embodiment, the sign code is described as being determined from the signs of non-zero elements.

Step 503. Multi-level permutation-based decoding is performed on the absolute vector code, to obtain an initial absolute vector.

A specific procedure of the multi-level permutation-based decoding includes the following.

The absolute vector value is decomposed, to obtain position codes of elements from the absolute vector at the upper-level absolute vector. Actually, the absolute vector code is consisted of position codes obtained in the multi-level permutation-based coding, thus the position codes related the respective levels may be obtained by decomposing directly the absolute vector code in decoding.

The position codes are decoded, thereby obtaining data on positions at the upper-level absolute vector for elements from the absolute vector.

The number of elements of the absolute vector at the upper level, and any element value of elements removed for obtaining the absolute vector are searched out from the preset decoding table.

The elements of the absolute vector are arranged in the absolute vector at the upper level in accordance with the data on position, and the element value of the removed elements is provided at the remaining position, so that the absolute vector at the upper level is obtained.

If the absolute vector at the upper level is not the initial absolute vector, the method proceeds with the multi-level permutation-based decoding in accordance with the steps above, until the initial absolute vector is obtained.

Step 504. The sign vector and the initial absolute vector are combined, thereby obtaining an initial vector.

Particularly, the signs are provided in order for the non-zero elements in the initial absolute vector.

It is possible that the last bit of the sign code is removed in coding due to the dependency of the signs of elements, therefore in reconstructing the initial vector, if the most right non-zero element of the initial vector is provided with no element sign, an element sign of the most right non-zero element may be determined in accordance with the principle that the sum of values of all elements in the initial vector is a multiple of 4. Of course, it is also possible that the most left non-zero element of the initial vector is provided with no element sign, depending on the non-zero element of which the sign is removed in coding.

As can be seen from this embodiment, no irregular factorial is calculated and amount of calculation is low in decoding using the solution according to the embodiment. Furthermore, the temporal data is similar with that for coding, and therefore not much storage space is occupied.

In practice, if the obtained code is a final code combined with a characteristic value of the characteristic codebook in the codebook space, the final code is required to be decomposed with the following steps:

determining a characteristic codebook corresponding to the initial vector from the final code of the initial vector, thereby obtaining a characteristic value of the characteristic codebook in the codebook space; and

determining a vector code of the initial vector which belongs to the characteristic codebook from the final code and the characteristic value.

The characteristic value may be an entirely shifted value. Due to that a storage position of each characteristic codebook in the codebook space is fixed, the entirely shifted value of the characteristic codebook in the codebook space is fixed, and the characteristic codebook where the coded value is may be determined from the range where the coded value is after the code is obtained. Particularly, a table, in which each characteristic codebook and its shift value are recorded, may be stored in a system. The table may be searched for decoding. Likewise, a similar process is performed for the case where the characteristic value is a serial number of the characteristic codebook.

Particularly, if the code is obtained by adding a code of the vector which belongs to the characteristic codebook and the entirely shifted value in coding, the coded value belonging to the characteristic codebook may be obtained by subtracting the entirely shifted value from the code.

With the above steps, the code of the vector which belongs to the characteristic codebook may be obtained by decomposing the final code, thereby decomposing the coded value of the vector which belongs to the characteristic codebook to obtain the initial vector.

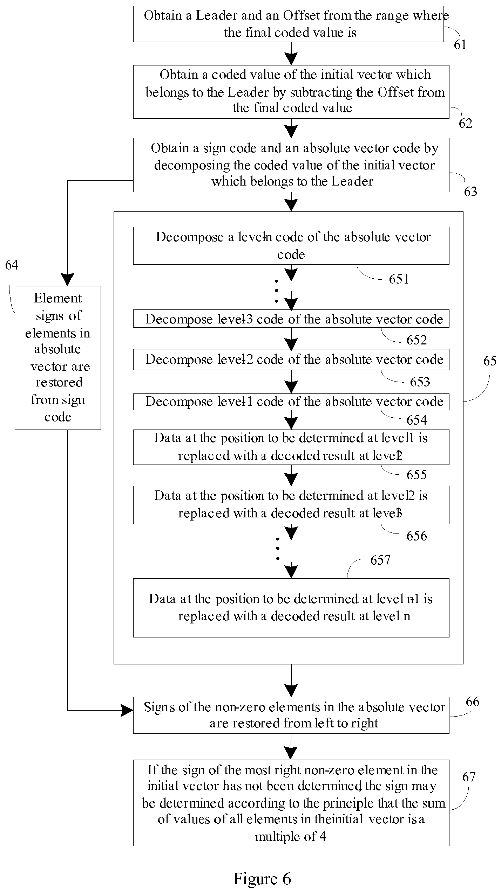

The vector decoding method according to the second embodiment of the present invention is shown in Figure 6, and includes the following.

Step 61. A Leader and an Offset are obtained from the range where the final coded value is.

Given the coded value of 59260, it may be determined that the coded value belongs to Leader 20, and the Offset is 57728.

Step 62. A coded value of the initial vector which belongs to the Leader may be obtained by subtracting the Offset from the final coded value.

A coded value of 1532 which belongs to Leader 20 is obtained by subtracting 57728 from 59260.

Step 63. A sign code and an absolute vector code are obtained by decomposing the coded value of the initial vector which belongs to the Leader.

A sign code of 4 and an absolute vector code of 1528 are obtained by decomposing 1532.

Step 64. Element signs of elements in the absolute vector are restored from the sign code.

A decimal 4 is converted to a binary 100 given that "1" represents the negative sign and "0" represents the positive sign in coding, therefore element signs corresponding to the non-zero elements indicate respectively "-", "+" and "+" from left to right.

Step 65. Multi-level permutation-based decoding is performed, which includes:

Step 651. A level-n code of the absolute vector code is decomposed.

The n indicates the number of levels of the multi-level permutation-based coding used in coding. The value of n may vary with different characteristic codebook, and may be obtained directly from item Vc in Table 2.

This embodiment is described taking Leader 20 as an example. As can be seen from Table 2, there are 4 levels, any element having an element value of 0 is removed at level 1, any element having an element value of 2 is removed at level 2, and any element having an element value of 4 is removed at level 3, as a result, the level 4 has an element having a value of 6. It will be noted that sign bits of the absolute vector code are shifted right by 3 bits (corresponding to the shift by 3 bits in coding) before decomposition, and obtains 191 from $1528/(2^3)=1528/8$.

Step 652. The level-3 code of the absolute vector code is decomposed.

For example, in the case of Leader 20, there are 4 levels, but decomposition will not be carried out at the level 4, and only 3 levels of permutation-based coding are carried out for Leader 20, accordingly, the decoding starts with the level 3. Because any element corresponding to one element value is removed at each level during the coding, any element corresponding to one element value is restored correspondingly at each level during decoding. As can be seen from Table 2 that m3 is 1, m2 is 2 and m1 is 3, the number of combinations obtained from selecting elements the number of which is the number of elements at level 2 from elements the number of which is the number of elements at level 3, i.e. 1 out of 2, is 2. Therefore, according to a calculation of 191%2, the obtained quotient is 95, which is a permutation-based position code for levels 1 and 2, the remainder is 1, which is a position code of an element from the absolute vector at level 3 at the absolute vector at level 2, and position data corresponding to the position code is 1.

Step 653. The level-2 code of the absolute vector code is decomposed.

Similarly, according to a calculation of 95%3, the obtained position code for level 1 is 31, the remainder is 2, which is a position code of an element from the absolute vector at level 2 at the absolute vector at level 1, and position data corresponding to the position code is 1 and 2.

Step 654. The level-1 code of the absolute vector code is decomposed.

Because the level 1 is the last level, a position code of an element from the level-1 absolute vector at the initial vector is obtained. Further, m1 is 3 and the number of bits of the initial data is 8, thus position data of 1, 4 and 6 which corresponds to the position code of 31 is searched out from the table shown in Figure 3a. It will be appreciated that the position data may be also calculated with a formula.

Step 655. Data at the position to be determined at the level 1 is replaced with a decoded result at the level 2.

As shown in Table 2, the element value removed first is 0, thus 0 is set at positions in the absolute vector other than positions 1, 4 and 6.

Step 656. Data at the position to be determined at the level 2 is replaced with a decoded result at the level 3.

As shown in Table 2, the element value removed secondly is 2, and positions 4 and 6 among the positions 1, 4 and 6 in the absolute vector is retained at the lower level, thus the element value of 2 is provided at the position 1.

Accordingly, the element value of 4 is provided at the position 4 and the element value of 6 is provided at the position 6, thereby obtaining the initial absolute vector of (0, 2, 0, 0, 4, 0, 6, 0).

No step for levels 4 to n is carried out because decoding for 3 levels only is required for Leader 20. In practice, for a certain Leader corresponding to many levels, process for each level is similar, and description thereof is omitted herein.

Step 657. Data at the position to be determined at the level n-1 is replaced with a decoded result at the level n.

Step 66. Signs of the non-zero elements in the absolute vector are restored from left to right.

The obtained signs of the non-zero elements are respectively "-", "+" and "+" from left to right, thus an initial vector of (0, -2, 0, 0, 4, 0, 6, 0) is obtained.

Step 67. If the sign of the most right non-zero element in the initial vector has not been determined, the sign of this non-zero element may be determined according to the principle that the sum of values of all elements in the initial vector is a multiple of 4.

In practice, it is possible that the sign bit for the most right non-zero element is removed due to the dependency of the signs of initial vector, therefore in decoding, if the most right non-zero element of the obtained initial vector is provided with no sign value, the sign of the most right non-zero element may be determined in accordance with the principle that the sum of values of all elements in the initial vector is a multiple of 4.

As can be seen in the embodiment, no irregular factorial is calculated and amount of calculation is low in decoding using the solution according to the embodiment. Furthermore, the temporal data is similar with that for coding, and therefore not much storage space is occupied.

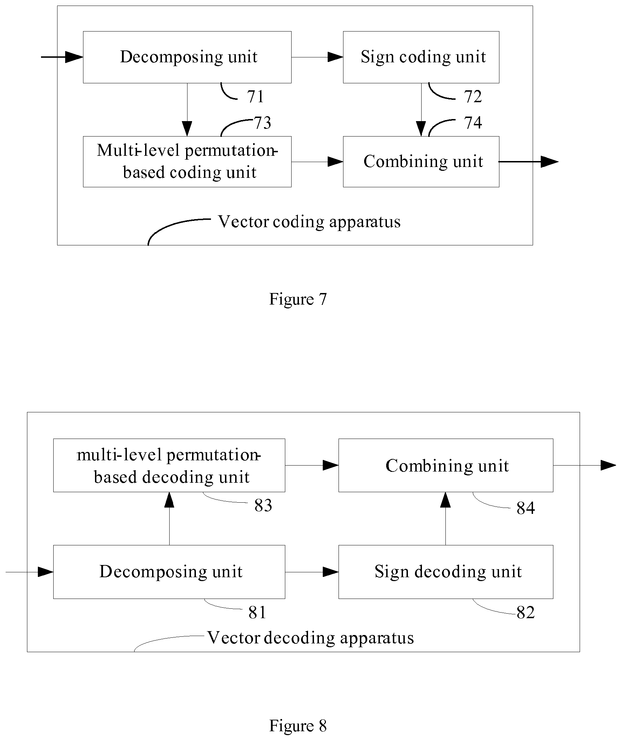

A vector coding apparatus according to an embodiment of the present invention is provided, as shown in Figure 7, and the apparatus includes:

a decomposing unit 71, adapted for decomposing an initial vector to obtain a sign vector and an initial absolute vector;

a sign coding unit 72, adapted for coding the sign to obtain a sign code;

a multi-level permutation-based coding unit 73, adapted for performing multi-level permutation-based coding on the initial absolute vector to obtain an absolute vector code. The multi-level permutation-based coding unit 73 may include: an element removing unit adapted for removing an element of the initial absolute vector which has a value satisfying a preset condition; an element retaining unit adapted for retaining in order any element not satisfying the preset condition to construct a new absolute vector; an position coding unit adapted for coding the position of the element not satisfying the preset condition in the initial absolute vector to obtain a position code, and triggering the element removing unit to remove any element in the new absolute vector of which the element value does not satisfy the preset condition if the number of the element values in the new absolute vector is larger than 1; and an absolute vector code unit adapted for combining the individual position codes obtained in multi-level permutation-based coding to obtain an absolute vector code if the number of the element values in the new absolute vector is larger than 1;

where the position coding unit may calculate the position code with a preset position code calculating formula, or search a preset position code table for the position code. In practice, the multi-level permutation-based coding unit 73 may further include a preset code table storage unit adapted for storing the preset code table in which the preset condition is stored, and the element removing unit searches the preset code table for any element to be removed; and

a combining unit 74, adapted for combining the sign code and the absolute vector code to obtain an initial vector code; The combining unit 74 may include: a bit number determining unit adapted for determining the number of bits of a sign code; and a combining unit adapted for shifting left the absolute vector code by the number of bits of the sign code and combining the sign code to obtain the initial vector code.

As can be seen, the absolute vector is coded using an approach of multi-level permutation-based coding in the embodiment, so that no calculation with complex formulas is conducted, and computation complexity is lowered.

In practice, if the number of characteristic codebook in a codebook space is at least two, the code of the initial vector needs to be mapped to the characteristic codebook. To this end, the vector coding apparatus according to the embodiment of the present invention further includes:

a characteristic codebook determining unit adapted for determining a characteristic codebook to which the initial vector belongs; and

a final coded value obtaining unit adapted for obtaining a characteristic value of the characteristic codebook and combining the characteristic value and the code of the initial vector to obtain a final code of the initial vector.

The final coded value obtaining unit may be used to map the initial vector to a corresponding characteristic codebook if multiple characteristic codebooks are present.

A vector decoding apparatus according to an embodiment of the present invention is provided, as shown in Figure 8, and the apparatus includes:

a decomposing unit 81 adapted for decomposing a vector code to obtain a sign code and an absolute vector code;

where the decomposing unit 81 may include: a sign code bit number determining unit adapted for determining the number of bits of a sign code from a characteristic codebook to which the initial vector belongs; a sign code extracting unit adapted for extracting data on bits of the sign code from the vector code to obtain the sign code; and an absolute vector code obtaining unit adapted for shifting right the vector code from which the data on the bits of the sign code has been extracted by the number of bits of the sign code to obtain an absolute vector code;

a sign decoding unit 82 adapted for decoding the sign code to obtain a sign vector;

a multi-level permutation-based decoding unit 83 adapted for performing multi-level permutation-based decoding on the absolute vector code to obtain an initial absolute vector;

where the multi-level permutation-based decoding unit 83 may include: an absolute vector code decomposing unit, adapted for decomposing the absolute vector code to obtain a position code of an element from the absolute vector at an absolute vector at an upper level, and an absolute vector code at the upper level; a position data obtaining unit adapted for decoding the position code to obtain data on position at an upper-level absolute vector for an element from the absolute vector; a data searching unit adapted for searching a preset decoding table for the number of elements in an absolute vector at the upper level, and an element value of the element removed in obtaining the absolute vector; and an absolute vector obtaining unit adapted for arranging elements from the absolute vector at an absolute vector at the upper level in accordance with the position data and providing the element value of the removed element at the remaining position to obtain the absolute vector at the upper level, and triggering the position data obtaining unit to decode the position code corresponding to the absolute vector at the upper level if the absolute vector at the upper level is not the initial absolute vector; the position data obtaining unit may calculate the position code with a preset position data decoding formula, or search a preset position data decoding table for the position data; and

a combining unit 84 adapted for combining the sign vector and the initial absolute vector to obtain an initial vector.

As can be seen, the absolute vector is coded using an approach of multi-level permutation-based coding in the embodiment, so that no calculation with complex formulas is conducted, and computation complexity is lowered.

In practice, if a plurality of characteristic codebooks are involved in the coding, the final coded value of the initial vector is obtained in the decoding, thus the vector decoding apparatus according to an embodiment of the present invention may further include:

a characteristic codebook determining unit adapted for determining a characteristic codebook to which the initial vector corresponds, and obtaining a characteristic value of the characteristic codebook in the codebook space; and a coded value determining unit adapted for decomposing a final code of the initial vector in accordance with the characteristic value to obtain a code of the initial vector.

After the code of the initial vector is obtained, the decomposing unit may start to decode the vector.

A stream media player including a vector decoding apparatus according to an embodiment of the present invention is provided, and the vector decoding apparatus includes:

a decomposing unit adapted for decomposing a vector code to obtain a sign code and an absolute vector code;

a sign decoding unit adapted for decoding the sign code to obtain a sign vector;

a multi-level permutation-based decoding unit adapted for performing multi-level permutation-based decoding on the absolute vector code to obtain an initial absolute vector; and

a combining unit adapted for combining the sign vector and the initial absolute vector to obtain an initial vector.

As can be seen, the absolute vector is coded using an approach of multi-level permutation-based coding in the embodiment, so that no calculation with complex formulas is conducted, and computation complexity is lowered.

It will be appreciated to those ordinarily skilled in the art that all or part of the above steps of the method according to the embodiments may be accomplished with a program instructing the related hardware, and the program may be stored on a computer-readable storage medium, and carry out the following steps when executed:
decomposing an initial vector to obtain a sign vector and an initial absolute vector; coding the sign vector to obtain a sign code; performing multi-level permutation-based coding on the initial absolute vector to obtain an absolute vector code; and combining the sign code and the absolute vector code to obtain a code of the initial vector.

The above-mentioned storage medium may be an ROM, a magnetic disk, a CD, etc.

The vector coding/decoding method, apparatus and the stream media player according to embodiments of the present invention have been described in detail. The embodiments are described for the purpose of better understanding of the method and its concept in the present invention.

**Claims**

1. A vector coding method, comprising:

decomposing (101) an initial vector to obtain a sign vector and an initial absolute vector, wherein the initial vector corresponds to a leader;
coding (102) the sign vector to obtain a sign code;
performing (103) multi-level permutation-based coding on the initial absolute vector to obtain an absolute vector code; and
combining (104) the sign code and the absolute vector code to obtain a code of the initial vector by adding the absolute vector code shifted left by the number of bits of the sign code to the sign code;
wherein coding the sign vector to obtain a sign code comprises: coding signs in the sign vector which correspond to non-zero elements from the inputted vector in order, to obtain the sign code with 1 representing a positive sign and 0 representing a negative sign, or 0 representing a positive sign and 1 representing a negative sign for each non-zero element;
wherein performing multi-level permutation-based coding on the initial absolute vector comprises:

(a) removing from the initial absolute vector any element according to a decomposition order wherein the decomposition order is configured to remove the most frequent element from the initial absolute vector, or remove the smallest element if two or more most frequent elements exist from the initial absolute vector, thereby constructing a new absolute vector with elements not removed, wherein the decomposition order is determined by the leader;

(b) performing permutation coding on positions of the elements not removed in the initial absolute vector to obtain a position code;
(c) proceeding with the multi-level permutation-based coding by repeating steps (a) and (b) on the new absolute vector if the number of elements in the new absolute vector is larger than 1, till the number of the elements in the new absolute vector is one; and
(d) obtaining the absolute vector code by combining all the position codes obtained in the multi-level permutation-based coding if the number of the elements in the new absolute vector is 1.

**2.** The method according to claim 1, further comprising:

determining a characteristic codebook to which the initial vector belongs, before decomposing an initial vector; and
obtaining a characteristic value of the characteristic codebook and combining the characteristic value and the code of the initial vector to obtain a final code of the initial vector, after obtaining the code of the initial vector.

**3.** The method of claim 1 or 2, the position code is calculated using a preset position code calculating formula, or searched out in a preset position code table.

**4.** A vector coding apparatus, configured to perform any of the methods according to claim 1 to 3.

**Patentansprüche**

**1.** Vektorcodierungsverfahren, umfassend:

Zerlegen (101) eines anfänglichen Vektors, um einen Vorzeichenvektor und einen anfänglichen Absolutvektor zu erhalten, wobei der anfängliche Vektor einem "Leader" entspricht;
Codieren (102) des Vorzeichenvektors, um einen Vorzeichencode zu erhalten;
Ausführen (103) von auf Permutation basierender Codierung auf mehreren Ebenen an dem anfänglichen Absolutvektor, um einen Absolutvektorcode zu erhalten; und
Kombinieren (104) des Vorzeichencodes und des Absolutvektorcodes, um einen Code des anfänglichen Vektors zu erhalten, durch Addieren des um die Anzahl von Bit des Vorzeichencodes nach links verschoben Absolutvektorcodes zu dem Vorzeichencode;
wobei Codieren des Vorzeichenvektors um einen Vorzeichencode zu erhalten, Folgendes umfasst: Codieren von Vorzeichen in dem Vorzeichenvektor, die von 0 verschiedenen Elementen aus dem eingegebenen Vektor entsprechen, der Reihe nach, um für jedes von 0 verschiedene Element den Vorzeichencode zu erhalten, wobei 1 ein positives Vorzeichen repräsentiert und 0 ein negatives Vorzeichen repräsentiert oder 0 ein positives Vorzeichen repräsentiert und 1 ein negatives Vorzeichen repräsentiert;
wobei Ausführen von auf Permutation basierender Codierung auf mehreren Ebenen an den anfänglichen Absolutvektor Folgendes umfasst:

(a) Entfernen jedes Elements aus dem anfänglichen Absolutvektor gemäß einer Zerlegungsreihenfolge, wobei die Zerlegungsreihenfolge ausgelegt ist zum Entfernen des häufigsten Elements aus dem anfänglichen Absolutvektor oder Entfernen des kleinsten Elements, wenn es zwei oder mehr häufigste Elemente gibt, aus dem anfänglichen Absolutvektor, um dadurch einen neuen Absolutvektor mit nicht entfernten Elementen zu konstruieren, wobei die Zerlegungsreihenfolge durch den "Leader" bestimmt wird;
(b) Ausführen von Permutationscodierung an Positionen der nicht in dem anfänglichen Absolutvektor entfernten Elemente, um einen Positionscode zu erhalten;
(c) Voranschreiten mit der auf Permutation basierenden Codierung auf mehreren Ebenen durch Wiederholen der Schritte (a) und (b) an dem neuen Absolutvektor, wenn die Anzahl der Elemente in dem neuen Absolutvektor größer als 1 ist, bis die Anzahl der Elemente in dem neuen Absolutvektor 1 ist; und
(d) Erhalten des Absolutvektorcodes durch Kombinieren aller Positionscodes, die in der auf Permutation basierenden Codierung auf mehreren Ebenen erhalten werden, wenn die Anzahl der Elemente in dem neuen Absolutvektor 1 ist.

**2.** Verfahren nach Anspruch 1, ferner umfassend:

Bestimmen eines charakteristischen Codebuchs, zu dem der anfängliche Vektor gehört, vor dem Zerlegen eines anfänglichen Vektors; und

Erhalten eines charakteristischen Werts des charakteristischen Codebuchs und Kombinieren des charakteristischen Werts und des Codes des anfänglichen Vektors, um einen Endcode des anfänglichen Vektors zu erhalten, nach dem Erhalten des Codes des anfänglichen Vektors.

**3.** Verfahren nach Anspruch 1 oder 2, wobei der Positionscode unter Verwendung einer voreingestellten Positionscode-Berechnungsformel berechnet oder in einer voreingestellten Positionscodetabelle herausgesucht wird.

**4.** Vektorcodierungsvorrichtung, die dafür ausgelegt ist, beliebige der Verfahren nach Anspruch 1 bis 3 auszuführen.

**Revendications**

**1.** Procédé de codage de vecteurs, comprenant :

la décomposition (101) d'un vecteur initial pour obtenir un vecteur de signe et un vecteur absolu initial, dans lequel le vecteur initial correspond à une amorce ;

le codage (102) du vecteur de signe pour obtenir un code de signe ;

l'exécution (103) d'un codage basé sur une permutation multiniveaux sur le vecteur absolu initial pour obtenir un code de vecteur absolu ; et

la combinaison (104) du code de signe et du code de vecteur absolu pour obtenir un code du vecteur initial en ajoutant le code de vecteur absolu décalé vers la gauche par le nombre de bits du code de signe au code de signe ;

dans lequel le codage du vecteur de signe pour obtenir un code de signe comprend : le codage de signes dans le vecteur de signe qui correspondent à des éléments non nuls à partir du vecteur entré dans l'ordre, pour obtenir le code de signe avec 1 qui représente un signe positif et 0 qui représente un signe négatif, ou 0 qui représente un signe positif et 1 qui représente un signe négatif pour chaque élément non nul ;

dans lequel l'exécution d'un codage basé sur une permutation multiniveaux sur le vecteur absolu initial comprend :

(a) la suppression, du vecteur absolu initial, d'un quelconque élément en fonction d'un ordre de décomposition dans lequel l'ordre de décomposition est configuré pour supprimer l'élément le plus fréquent du vecteur absolu initial, ou pour supprimer le plus petit élément, si deux éléments les plus fréquents, ou plus, existent, du vecteur absolu initial, ce qui permet de construire un nouveau vecteur absolu avec des éléments non supprimés, dans lequel l'ordre de décomposition est déterminé par l'amorce ;

(b) l'exécution d'un codage de permutation sur des positions des éléments non supprimés dans le vecteur absolu initial pour obtenir un code de position ;

(c) la poursuite du codage basé sur une permutation multiniveaux en répétant les étapes (a) et (b) sur le nouveau vecteur absolu si le nombre d'éléments dans le nouveau vecteur absolu est supérieur à 1, jusqu'à ce que le nombre des éléments dans le nouveau vecteur absolu soit un ; et

(d) l'obtention du code de vecteur absolu en combinant tous les codes de position obtenus dans le codage basé sur une permutation multiniveaux si le nombre des éléments dans le nouveau vecteur absolu est 1.

**2.** Procédé selon la revendication 1, comprenant en outre :

la détermination d'un livre de code caractéristique auquel appartient le vecteur initial, avant la décomposition d'un vecteur initial ; et

l'obtention d'une valeur caractéristique du livre de code caractéristique et la combinaison de la valeur caractéristique et du code du vecteur initial pour obtenir un code final du vecteur initial, après l'obtention du code du vecteur initial.

**3.** Procédé selon la revendication 1 ou 2, le code de position étant calculé en utilisant une formule de calcul de code de position prédéfinie, ou recherché dans une table de code de position prédéfinie.

**4.** Appareil de codage de vecteur, configuré pour mettre en œuvre l'un quelconque des procédés selon les revendications 1 à 3.

Decompose an initial vector to obtain a sign vector and an initial absolute vector

101

Code the sign vector to obtain a sign code

102

Perform multi-level permutation-based coding on the initial absolute vector to obtain an absolute vector code

103

Combine the sign code and the absolute vector code to obtain a code of the initial vector

104

Figure 1

Leader 20: (0,-2,0,0,4,0,6,0) $\longrightarrow$ (0,-1,0,0,1,0,1,0)

Leader 20: (0,2,0,0,4,0,6,0)

sign=4

(2,4,6)

(0,x,0,0,x,0,x,0)
3 out of 8: (1,4,6)
(o,x,o,o,x,o,x,o)

index=31

(4,6)

(2,x,x)
2 out of 3: (1,2)
(o,x,x)

index*=3=93
Index+=2=95

(6)

(4,x)
1 out of 2: (1)
(o,x)

index*=2=190
Index+=1=191

code=191*8+4=1532
code+=offset=59260

Figure 2

C(8,3)

0
C(7,2)

1
C(6,1)

1
C(6,2)

2
C(5,1)

2
C(5,2)

3
C(4,2)

4
C(3,2)

5
C(2,2)

0 1 2 3 4 5 6

2 3 4 5 6 7 3 4 5 6 7 4 5 6 7 5 6 7 6 7 7 3 4 5 6 7 4 5 6 7 5 6 7 6 7 7 4 5 6 7 5 5 6 7 7 6 7 7 5 6 7 7 6 7 7 7
0 1 2 3 4 5 6 7 8 9 10 11 12 13 14 15 16 17 18 19 20 21 22 23 24 25 26 27 28 29 30 31 32 33 34 35 36 37 38 39 40 41 42 43 44 45 46 47 48 49 50 51 52 53 54 55

Figure 3a

0   1

1 2 2
0 1 2

Figure 3b

Decompose an initial vector to obtain a sign vector and an absolute vector — 401

Arrange signs of non-zero elements in an order in which the non-zero elements are arranged in the initial vector to obtain a sign code, with "1" representing a positive sign and "0" representing a negative sign — 402

403

Yes

Are signs of the elements in the initial vector independent?

No — 404

Remove the last bit of the sign code

405

Remove any element which corresponds to the element value corresponding to the most elements is removed from the absolute vector

406

Obtain data on position in absolute vector for any element which corresponds to an element value not corresponding to the most elements, and calculate a position code by a preset approach

407

Yes

The number of element values not corresponding to the most elements is 1?

No — 408

Retain in order elements which correspond to element values not corresponding to the most elements, to construct a new absolute vector

409

Combine the obtained position codes into a combined position code, which is shifted left by the number of bits of the sign code and combined with the sign code to obtain a code of the initial vector which belongs to the characteristic codebook

410

Combine the code belonging to the characteristic codebook and the entirely shifted value of the characteristic codebook in the codebook space, to obtain a final coded value of the initial vector

Figure 4

Decompose a vector code to obtain a sign code and an absolute vector code
501

Decode sign code to obtain a sign vector
502

Perform multi-level permutation-based decoding on the absolute vector code to obtain an initial absolute vector
503

Combine sign vectors and initial absolute vector to obtain an initial vector
504

Figure 5

Obtain a Leader and an Offset from the range where the final coded value is — 61

Obtain a coded value of the initial vector which belongs to the Leader by subtracting the Offset from the final coded value — 62

Obtain a sign code and an absolute vector code by decomposing the coded value of the initial vector which belongs to the Leader — 63

64 Element signs of elements in absolute vector are restored from sign code

Decompose a level-n code of the absolute vector code — 651

Decompose level-3 code of the absolute vector code — 652

Decompose level-2 code of the absolute vector code — 653

Decompose level-1 code of the absolute vector code — 654

Data at the position to be determined at level-1 is replaced with a decoded result at level-2 — 655

Data at the position to be determined at level-2 is replaced with a decoded result at level-3 — 656

657

Data at the position to be determined at level n-1 is replaced with a decoded result at level n

65

Signs of the non-zero elements in the absolute vector are restored from left to right — 66

If the sign of the most right non-zero element in the initial vector has not been determined, the sign may be determined according to the principle that the sum of values of all elements in the initial vector is a multiple of 4 — 67

Figure 6

Decomposing unit

Sign coding unit

71

72

73

Multi-level permutation-based coding unit

74

Combining unit

Vector coding apparatus

Figure 7

multi-level permutation-based decoding unit

Combining unit

83

84

Decomposing unit

Sign decoding unit

81

82

Vector decoding apparatus

Figure 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070162236 A